# FASCICULE DE BREVET EUROPEEN

(11) **EP 1 318 607 B1**
(45) Date de publication et mention de la délivrance du brevet: **11.05.2005**
(21) Numéro de dépôt: 02292931.9
(22) Date de dépôt: 27.11.2002
(51) Int. Cl.: H03M 11/00, G06F 3/023, B60R 16/02

(54) **Procédé de gestion et d'exploitation d'un réseau comprenant des organes de consigne multiplexes, notamment pour véhicule automobile**
Verfahren zur Verwaltung und zum Betrieb eines Netzwerks von multiplexierten Steuervorrichtungen insbesondere für Automobile
Method for managing and operating a network of multiplexed controlling devices notably for motor vehicles

(30) Priorité: 10.12.2001 FR 0115938
(43) Date de publication de la demande: 11.06.2003
(73) Titulaire: Peugeot Citroen Automobiles SA, 92200 Neuilly sur Seine (FR)
(72) Inventeur: Chiariglione, Emmanuel, 92600 Asnieres (FR); Simon, Frédéric, 78310 Maurepas (FR)
(74) Mandataire: Thinat, Michel

(56) Documents cités:
- DE-A- 19 609 743
- FR-A- 2 670 635
- US-A- 5 844 500

## Description

La présente invention concerne de façon générale une technique de multiplexage optimisée, notamment applicable à la gestion des réseaux multiplexés embarqués sur les véhicules automobiles.

Plus précisément, l'invention concerne un procédé de gestion et d'exploitation d'un réseau de commande multiplexé comprenant au moins des premier et second organes de consigne appartenant à un ensemble d'organes de consigne multiplexés, une unité logique de commande, et des premier et second organes commandés appartenant à un ensemble d'organes commandés et respectivement associés aux premier et second organes de consigne, ce procédé comprenant au moins une procédure de consigne, dans laquelle au moins un organe de consigne, sélectionné parmi les premier et second organes de consigne par un organe de manipulation tel qu'un doigt d'un opérateur, est actionné par cet organe de manipulation et corrélativement déplacé d'un état initial vers un état final choisi parmi au moins deux états différents possibles, une procédure de scrutation, dans laquelle l'état de chaque organe de consigne est scruté par l'unité logique au moins pendant chaque cycle d'une série de cycles de scrutation successifs présentant chacun une durée au plus égale à une durée maximale déterminée, et une procédure de commande, dans laquelle l'unité logique réalise à chaque instant un pilotage des premier et second organes commandés en fonction des états respectifs des premier et second organes de consigne tels que relevés au cours d'un cycle de scrutation antérieur à cet instant.

Ce procédé, bien connu et largement utilisé, peut dans certaines conditions révéler quelques imperfections, comme c'est le cas lorsqu'il est mis en oeuvre sur un véhicule automobile.

En effet, la sophistication croissante de l'aménagement intérieur des véhicules automobiles et de leurs principaux organes fonctionnels a fait naître, ces dernières années, la nécessité de gérer un nombre de plus en plus important de signaux, pour permettre un pilotage contrôlé de ces véhicules et leur garantir confort, performances et sécurité.

Cette évolution a logiquement conduit à recourir à la technique du multiplexage, qui permet une exploitation centralisée de ces différentes informations tout en évitant une augmentation inconsidérée de la longueur des câbles nécessaires à leur transmission.

Malgré son indéniable intérêt, cette approche commence elle-même à montrer ses limites, dans la mesure où les réseaux multiplexés embarqués sur les véhicules, soumis à d'importantes contraintes d'encombrement, de poids et de coût, peuvent, en cas de surcharge, réagir à une nouvelle consigne avec un retard sensible qui perturbe le conducteur.

Le document US-A-5 844 500 divulgue un dispositif avec une interface homme-machine pour l'usage comme interface de commande d'utilisateur, en particulier dans un environnement des véhicules à moteur.

La présente invention s'inscrit dans ce contexte et a pour but de proposer un procédé de gestion et d'exploitation d'un réseau de commande comprenant un ensemble d'organes de consigne multiplexés, ce procédé étant capable de prendre en compte les consignes d'un opérateur sans imposer à ce dernier une attente perceptible.

A cette fin, le procédé de l'invention, par ailleurs conforme à la définition générique qu'en donne le préambule ci-dessus, est essentiellement caractérisé en ce que la procédure de consigne met au moins en oeuvre un détecteur de proximité émettant un signal d'alerte en cas de détection d'une première condition de proximité réalisée entre l'organe de manipulation et le premier organe de consigne et annonçant la sélection de ce premier organe de consigne, et en ce que le signal d'alerte ainsi émis est utilisé par l'unité logique pour écourter la durée d'au moins un prochain cycle de scrutation du premier organe de consigne, et / ou préparer une modification du pilotage du premier organe commandé, en fonction d'un possible changement d'état du premier organe de consigne.

Dans un mode de réalisation préféré de l'invention, la première condition de proximité est réalisée lorsque l'organe de manipulation est séparé de l'emplacement désigné par une distance inférieure à un premier seuil déterminé.

La procédure de consigne peut mettre au moins en oeuvre des premier et second détecteurs de proximité émettant des premier et second signaux d'alerte respectifs dès qu'ils détectent que la première condition de proximité est réalisée respectivement entre les premier et second organes de consigne et l'organe de manipulation, annonçant respectivement la sélection des premier et second organes de consigne, et chaque signal d'alerte ainsi émis peut être utilisé par l'unité logique pour écourter la durée d'au moins un prochain cycle de scrutation de l'organe de consigne sélectionné ou en passe de l'être, et / ou préparer, en fonction d'un possible changement d'état de l'organe de consigne sélectionné ou en passe de l'être, une modification du pilotage de l'organe commandé qui est associé à l'organe de consigne sélectionné ou en passe de l'être.

Les premier et second organes de consigne sont par exemple disposés en des premier et second emplacements respectifs auxquels sont aussi respectivement disposés les premier et second détecteurs de proximité, et des premier et second émetteurs de signaux d'information avec lesquels les premier et second organes de consigne et les premier et second détecteurs de proximité sont ainsi respectivement mis en correspondance, et chaque émetteur est alors avantageusement conçu pour produire, en cas d'émission d'un signal d'alerte par le détecteur de proximité correspondant, un signal d'information rappelant à l'opérateur quel organe commandé est associé à l'organe de consigne qui correspond à l'émetteur de ce signal d'information.

En particulier, les premier et second organes de consigne peuvent être disposés en des premier et second emplacements respectifs, chacun des premier et second organes de consigne peut adopter sélectivement un état actif ou un état passif, et la procédure de commande peut comprendre une sous-procédure de validation, consistant au moins à produire un signal de validation à chacun des premier et second emplacements où est disposé un organe de consigne placé dans son état actif.

Au lieu d'affecter un détecteur de proximité à chaque organe de consigne, il est possible d'affecter un détecteur de proximité à un groupe d'organes de consigne.

Ainsi, le détecteur de proximité peut être disposé de manière à pouvoir détecter une réalisation de la première condition de proximité entre l'organe de manipulation et l'un ou l'autre des premier et second organes de consigne, le signal d'alerte émis par ce détecteur de proximité annonçant ainsi la sélection de l'un ou l'autre des premier et second organes de consigne, et ce signal d'alerte est alors utilisé par l'unité logique pour écourter la durée d'au moins un prochain cycle de scrutation des premier et second organes de consigne, et / ou préparer une modification du pilotage des premier et second organes commandés, en fonction d'un possible changement des états des premier et second organes de consigne.

Par exemple, le détecteur de proximité peut être porté par un combinateur d'un véhicule automobile, les premier et second organes de consigne étant constitués par des contacts électriques et / ou des rhéostats portés par ce combinateur.

Plus généralement, les organes de consigne peuvent être constitués, de façon classique, par des boutons, des interrupteurs ou des potentiomètres.

Cependant, il est avantageux de faire en sorte que les premier et second détecteurs constituent eux-mêmes les premier et second organes de consigne, chaque organe de consigne étant sensible à une seconde condition de proximité entre lui-même et l'organe de manipulation, et changeant d'état par réalisation de cette seconde condition de proximité.

La fonction assignée à l'organe de consigne disposé à l'emplacement désigné par l'approche de l'organe de manipulation peut ainsi passer d'un état passif à un état actif par réalisation de la seconde condition de proximité à cet emplacement désigné.

Dans ce cas, il peut en outre être utile de prévoir que les premier et second organes de consigne présentent un fonctionnement bistable, de sorte que la fonction assignée à l'organe de consigne disposé à l'emplacement désigné par l'approche de l'organe de manipulation puisse également passer d'un état actif à un état passif par réalisation de la seconde condition de proximité à cet emplacement désigné.

La seconde condition de- proximité est par exemple réalisée lorsque la distance séparant l'organe de manipulation de l'emplacement désigné par l'approche de l'organe de manipulation est inférieure à un second seuil déterminé, inférieur au premier seuil.

Selon une variante possible, la seconde condition de proximité est réalisée lorsque l'organe de manipulation est séparé de l'emplacement désigné par une distance qui diminue à une vitesse supérieure à une vitesse limite déterminée.

Le signal d'information est par exemple constitué par un signal lumineux, un signal sonore, un signal vibratoire, ou un message parlé, tandis que le signal de validation comprend de préférence un signal lumineux, éventuellement doublé d'un signal audible produit à l'instant de la validation.

Dans le cas où le procédé de l'invention est appliqué à un réseau de commande multiplexé embarqué sur un véhicule automobile, chaque emplacement appartient à un poste de conduite de ce véhicule.

En plus des éléments déjà évoqués, les moyens d'information peuvent comprendre au moins un relief prévu sur le tableau de bord et formant un guide tactile pour l'organe de manipulation.

Pour réduire le nombre d'informations pertinentes affichées simultanément, il est possible de faire en sorte qu'en l'absence de tout signal, les premier et second emplacements soient indifférenciés sur le tableau de bord.

Les premier et seconds détecteurs de proximité et les premier et second émetteurs de signaux d'information sont par exemple disposés sous un panneau translucide du tableau de bord.

L'un au moins des premier et second détecteurs de proximité peut être constitué par un capteur capacitif dépourvu de pièce mobile.

Cependant, il est également possible de prévoir que l'un au moins des premier et second détecteurs de proximité soit un capteur capacitif doté d'une armature mobile sélectivement déplacée par l'organe de manipulation à l'encontre d'une force élastique de rappel.

D'autres caractéristiques et avantages de l'invention ressortiront clairement de la description qui en est faite ci-après, à titre indicatif et nullement limitatif, en référence aux dessins annexés, dans lesquels:
- la Figure 1 est un schéma général d'un réseau mettant en oeuvre le procédé de l'invention;
- les Figures 2A et 2B sont des diagrammes temporels illustrant de façon schématique le principe de l'invention;
- les Figures 3A à 3E sont des vues schématiques d'un tableau de bord géré par un procédé conforme à l'invention et représenté dans plusieurs états;
- la Figure 4 est un schéma d'un arrangement comprenant un organe de consigne, un détecteur et un émetteur, et dans lequel le détecteur et l'organe de consigne sont physiquement distincts l'un de l'autre, cet arrangement étant géré par un procédé conforme à l'invention;
- la Figure 5 est un schéma d'un arrangement comprenant un organe de consigne, un détecteur et un émetteur, et dans lequel le détecteur et l'organe de consigne sont physiquement indifférenciés l'un de l'autre, cet arrangement étant géré par un procédé conforme à l'invention;
- la Figure 6 est un schéma d'un détecteur utilisable dans un procédé conforme à l'invention; et
- la Figure 7 est une vue schématique d'un combinateur utilisable dans le procédé de l'invention.

Comme annoncé précédemment, l'invention concerne un procédé de gestion et d'exploitation d'un réseau de commande multiplexé.

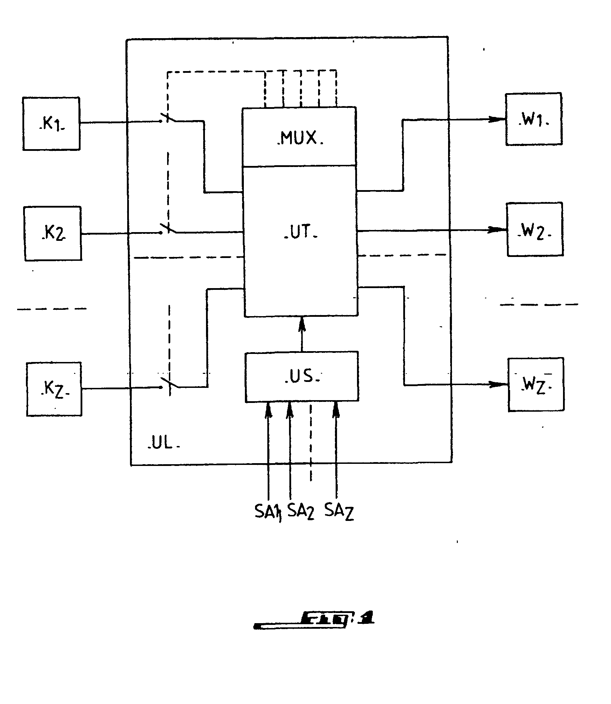

Ce réseau comprend (figure 1) une pluralité d'organes de consigne multiplexés K1, K2, ..., Kz, une unité logique de commande UL, et une pluralité d'organes commandés W1, W2, ..., Wz respectivement associés aux organes de consigne K1, K2, ..., Kz.

Par souci de concision, la description considérera principalement deux organes de consigne, notés K1 et K2, respectivement associés à deux organes commandés W1 et W2 auxquels sont assignées des fonctions respectives différentes, telles que l'éclairage, le dégivrage de la lunette arrière, l'air conditionné, la ventilation, etc. dans le cas où le procédé est appliqué à un véhicule automobile, étant cependant entendu que l'invention n'est pas du tout limitée à la gestion de deux organes de consigne seulement.

Ces organes de consigne K1 et K2 sont disposés en des emplacements respectifs, par exemple en deux emplacements X1 et X2 d'un poste de conduite ou d'un tableau de bord B d'un véhicule automobile.

Par ailleurs, pour faciliter la compréhension de l'invention, la présente description utilisera par convention les indices 1 et 2 comme des repères spécifiquement attribués aux éléments respectivement disposés aux emplacements X1 et X2.

Ainsi, par exemple, dans la mesure où un organe de consigne est génériquement désigné par la référence K, la référence K1 désignera l'organe de consigne qui est disposé à l'emplacement X1.

Ce procédé comprend une procédure de consigne, c'est-à-dire qu'il inclut des opérations qui permettent d'utiliser les organes de consigne K1 et K2.

Dans le cadre de cette procédure, chacun des organes de consigne K1 et K2 peut être individuellement sélectionné par le doigt O ou la main d'un opérateur, ce doigt ou cette main remplissant donc la fonction d'un organe de manipulation, permettant d'opérer un changement d'état de l'organe de consigne K1 ou K2 spécifiquement sélectionné, et permettant en fin de compte de contrôler la fonction assignée à l'organe commandé W1 ou W2 qui est associé à cet organe de consigne.

Ce procédé comprend par ailleurs une procédure de scrutation, dans laquelle l'état de chaque organe de consigne tel que K1 ou K2 est scruté de façon périodique ou pseudo-périodique par l'unité logique UL pour relever l'état adopté par cet organe de consigne.

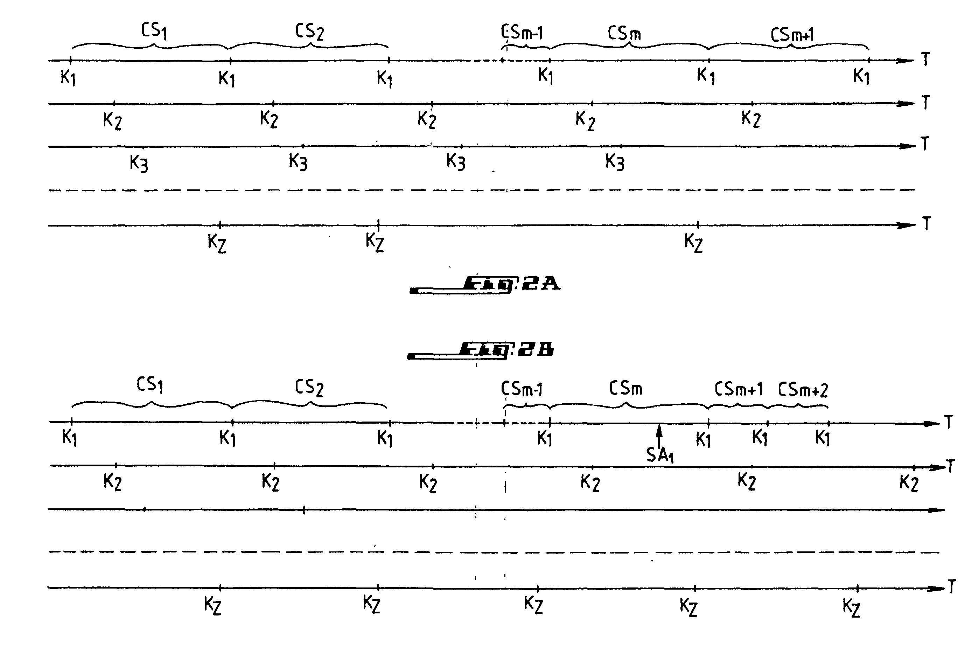

Plus précisément, l'unité logique UL comprend (figure 1) une unité de multiplexage MUX qui relie chaque organe de consigne K1 ou K2 à une unité de traitement UT au moins une fois sur chaque intervalle de temps de durée DT0, et concrètement (figure 2A) pendant chaque cycle d'une série indéfinie de cycles de scrutation successifs CSm de durée contrôlée par l'unité logique UL, l'indice "m" étant ici utilisé pour désigner un nombre entier variable quelconque.

Ce procédé comprend par ailleurs une procédure de commande, dans laquelle l'unité logique UL réalise à chaque instant Tm un pilotage des organes commandés W1 et W2 en fonction des états respectifs des organes de consigne K1 et K2, tels que relevés au cours du cycle de scrutation CSm-1 antérieur à cet instant Tm.

Selon l'invention, la procédure de consigne met en oeuvre un ou plusieurs détecteurs de proximité tels que D1, D2, Dz respectivement associés aux organes de consigne correspondants K1, K2, Kz, et respectivement disposés aux emplacements X1, X2, et Xz.

L'expression "détecteur de proximité" doit être ici comprise comme désignant de façon générique tout dispositif sensible à l'approche de l'organe de manipulation O que constitue un doigt, ou une main gantée ou non, et ne doit pas du tout être comprise comme désignant de façon limitative un dispositif qui servirait spécifiquement à mesurer la distance qui le sépare de l'organe de manipulation O.

Chacun de ces détecteurs, tel que D1 et D2, est conçu pour délivrer un signal d'alerte correspondant, tel que SA1 et SA2, dans le cas où le doigt O de l'opérateur s'approche suffisamment de l'emplacement X1 où X2 occupé par ce détecteur pour satisfaire à une première condition de proximité.

Cette première condition est par exemple réalisée lorsque la main ou le doigt O, s'approchant de l'emplacement X1 ou de l'emplacement X2, ne sont plus séparés de cet emplacement que par une distance L inférieure à un seuil déterminé Li.

Si le détecteur D1 ou D2 n'est pas en réalité directement sensible à la distance qui le sépare du doigt O, mais est seulement sensible à un paramètre physique qui dépend de cette distance, par exemple à une capacité électrique formée entre ce détecteur et le doigt O, ce détecteur est en fait réglé pour détecter que le paramètre physique auquel il est sensible franchit lui-même un seuil indiquant, au moins en première approximation, que la distance L tombe au-dessous du seuil Li.

Dans ces conditions, le signal d'alerte SA1, SA2, SAz délivré par chaque détecteur de proximité annonce la sélection, par l'organe de manipulation O, de l'organe de consigne associé à ce détecteur de proximité.

Dès qu'un signal d'alerte, par exemple le signal SA1, est ainsi émis, il est utilisé par l'unité logique UL pour écourter la durée d'au moins un prochain cycle de scrutation CSm+1 de l'organe de consigne correspondant, en l'occurrence de l'organe K1, et / ou pour préparer une modification du pilotage de l'organe commandé associé, en l'occurrence de l'organe W1, en fonction d'un possible changement d'état de l'organe de consigne concerné, K1 dans cet exemple.

L'unité logique UL comprend par exemple une unité de surveillance US (figure 1) qui, dès réception d'un signal d'alerte tel que SA1, informe l'unité de traitement UT de l'existence de ce signal et de l'identité du détecteur qui l'a produit.

Si par exemple (figure 2B) le signal SA1 est reçu par l'unité logique UL au cours du cycle CSm, le cadencement du multiplexeur MUX sera modifié, au moins pour la scrutation de l'organe de consigne K1, de manière que l'état de cet organe de consigne soit à nouveau scruté au cours d'un cycle suivant CSm+1 de durée raccourcie par rapport à celle qu'aurait eue ce même cycle CSm+1 en l'absence d'apparition du signal SA1 (figure 2A), de manière à prendre en compte, aussi tôt que possible, tout éventuel changement d'état de cet organe de consigne.

En plus ou à la place de cette mesure, l'unité logique UL peut, à réception du signal SA1, prendre des mesures pour préparer un changement d'état de l'organe commandé W1, dans le cas où une telle préparation est nécessaire pour changer l'état de cet organe commandé, où cette préparation requiert un certain temps, et où cette préparation peut être interrompue sans conduire inévitablement à un changement d'état de l'organe commandé.

Au lieu de prévoir un détecteur de proximité par organe de consigne, il est possible de ne prévoir qu'un détecteur de proximité pour un groupe de plusieurs organes de consigne.

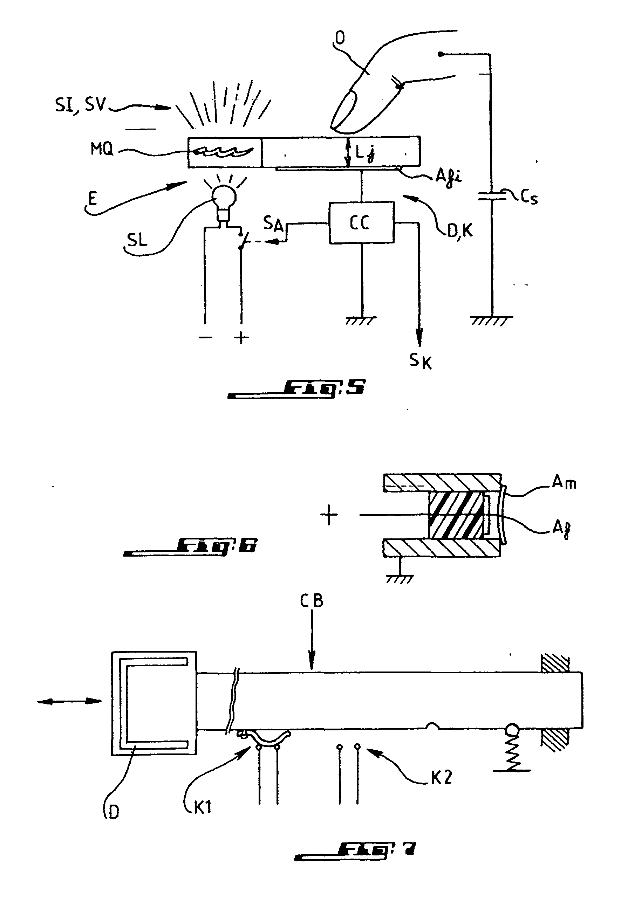

Cette possibilité est illustrée à la figure 7, qui représente un détecteur de proximité D prenant la forme d'un capteur capacitif et porté par un combinateur CB d'un véhicule automobile, ce combinateur commandant deux organes de consigne K1 et K2 constitués par des contacts électriques.

Dans ce cas, le détecteur de proximité D est disposé de manière à pouvoir détecter la réalisation de la première condition de proximité entre l'organe de manipulation O et l'un ou l'autre des organes de consigne K1 et K2.

Si cette condition se réalise, le détecteur D émet un signal d'alerte SA annonçant ainsi la sélection de l'un ou l'autre des organes de consigne K1 et K2.

Ce signal d'alerte SA peut alors être utilisé par l'unité logique UL pour écourter la durée d'un ou plusieurs cycles de scrutation suivants des deux organes de consigne K1 et K2 à la fois, et / ou préparer une modification du pilotage des organes commandés correspondants W1 et W2, en fonction d'un possible changement futur des états des organes de consigne K1 et K2.

Pour permettre à l'opérateur de savoir à quel organe commandé, et donc à quelle fonction, est associé un organe de consigne donné, le procédé peut avantageusement mettre en oeuvre des moyens d'information accessibles à cet opérateur avant toute action sur cette fonction.

Ainsi, dans le cas où le procédé de l'invention met en oeuvre des organes de consigne K1 et K2 disposés en des emplacements respectifs X1 et X2 auxquels sont aussi respectivement disposés les détecteurs de proximité D1 et D2, le procédé de l'invention peut inclure l'utilisation d'émetteurs E1 et E2 de signaux d'information, eux-mêmes localisés aux emplacements respectifs X1 et X2, et donc mis en correspondance avec les organes de consigne K1 et K2 et les détecteurs de proximité D1 et D2.

Chaque émetteur E1 ou E2, en cas d'émission d'un signal d'alerte SA1 ou SA2 par le détecteur de proximité D1 ou D2 correspondant, produit un signal d'information SI1 ou SI2 qui rappelle à l'opérateur quel organe commandé W1 ou W2 est associé à l'organe de consigne K1 ou K2 correspond à cet émetteur E1 ou E2.

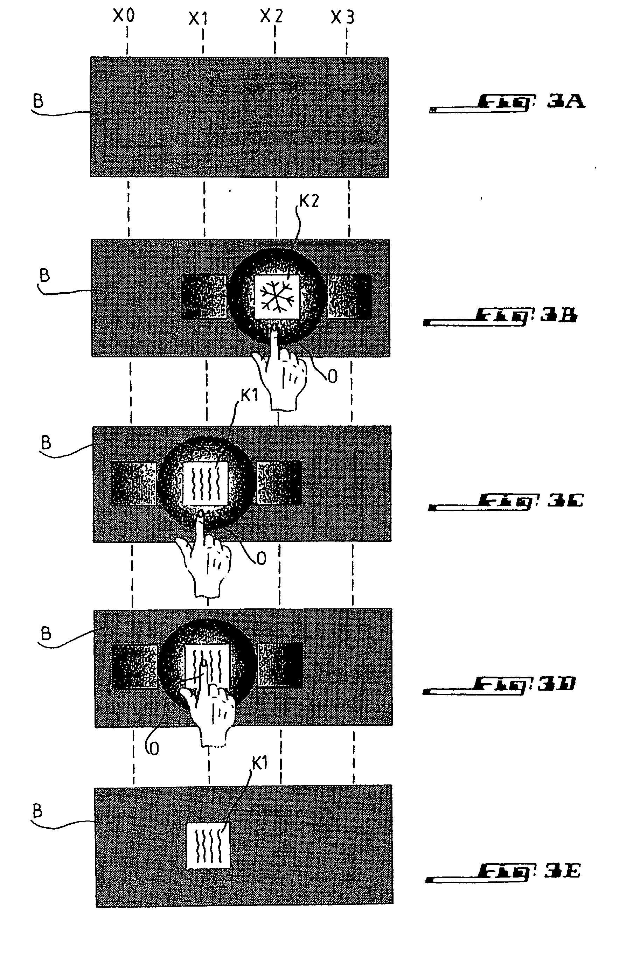

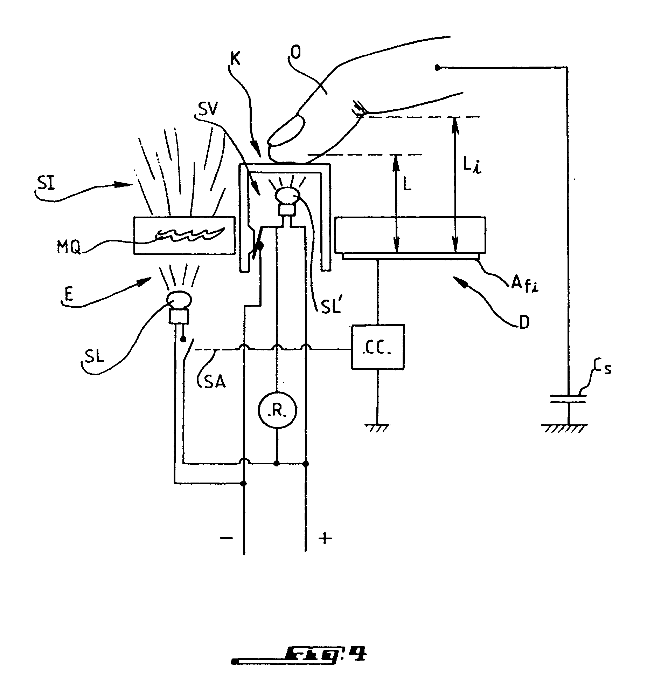

Comme le montrent les figures 4 et 5, chacun des émetteurs E1 et E2 est par exemple constitué par une source lumineuse SL alimentée électriquement sur commande, et par un masque MQ portant un symbole ou un pictogramme.

Chaque signal d'information, tel que SI1 et SI2, ainsi obtenu par éclairage du symbole ou du pictogramme, informe l'opérateur sur la nature de la fonction assignée à l'organe de consigne K1 ou K2 qui est disposé à celui des emplacements X1 ou X2 que cet opérateur désigne par l'approche de son doigt O.

En variante, les signaux d'information produits par les émetteurs E1 et E2 peuvent être constitués par des signaux audibles ou inclure de tels signaux, qui prennent par exemple la forme de bips, de signaux vibratoires, de mélodies, ou de messages parlés.

Une fois que l'opérateur a pu vérifier que la fonction assignée à l'organe de consigne K1 ou K2 qu'il désigne de son doigt O est bien celle sur laquelle il souhaite agir, il commande le changement d'état de cet organe de consigne, qui peut ainsi notamment passer de l'état passif à l'état actif, ou inversement, et activer ou désactiver corrélativement la fonction qu'il contrôle.

En outre la procédure de commande comprend de préférence une sous-procédure de validation qui, dans le cas où la fonction assurée par l'organe de commande W1 ou W2 associé à l'organe de consigne K1 ou K2 est activée, consiste au moins à produire un signal de validation SV1 ou SV2 correspondant, qui confirme à l'opérateur que la fonction assignée à l'organe de consigne K1 ou K2 réellement sélectionné a bien été activée, et qui rappelle à cet opérateur l'état actif de cette fonction.

Dans le cas où le procédé de l'invention est appliqué à un véhicule automobile, les détecteurs de proximité D1 et D2, et les émetteurs E1 et E2 de signaux d'information sont avantageusement disposés sous un panneau translucide et de couleur sombre, par exemple du tableau de bord, les signaux de validation SV1 et SV2 comprenant eux-mêmes de préférence des signaux lumineux, éventuellement doublés par des signaux audibles émis à l'instant d'un changement d'état.

Dans ces conditions, il est en particulier possible de faire en sorte qu'en l'absence de tout signal, les emplacements X1 et X2 soient indifférenciés sur le tableau de bord B du véhicule.

L'effet produit par les opérations décrites jusqu'à présent est illustré aux figures 3A à 3E.

La figure 3A représente un tableau de bord B donnant accès, en différents emplacements X0, X1 X2, et X3, à différentes fonctions assurées par les organes commandés correspondants W0 à W3, et dont les états respectifs sont contrôlés par les organes de consigne K0, K1, K2, et K3.

Dans l'état illustré, toutes ces fonctions sont inactives, de sorte que les organes de consigne ne sont pas éclairés et sont indifférenciés.

Si l'opérateur approche son doigt O de l'emplacement X2 (figure 3B), le détecteur D2 émet le signal d'alerte SA2 dès que la première condition de proximité est réalisée entre le doigt O et le détecteur D2.

Le signal d'alerte SA2 informe alors l'unité logique UL de la possibilité d'un actionnement imminent de l'organe de consigne K2, dont l'état est dorénavant scruté à une fréquence plus élevée.

Parallèlement, le signal d'alerte SA2 éveille l'émetteur E2, qui émet le signal d'information SI2.

Le signal SI2 éclaire un pictogramme informant l'opérateur que l'organe de consigne K2 est par exemple dédié à la commande de l'air conditionné, l'éclairage pouvant être suffisant pour permettre à l'opérateur de repérer les emplacements voisins X1 et X3.

L'opérateur, qui ne souhaite pas en l'occurrence modifier la commande de l'air conditionné, approche alors son doigt O de l'emplacement X1 (figure 3C), et le détecteur D1 émet le signal d'alerte SA1 dès que la première condition de proximité est réalisée entre le doigt O et le détecteur D1.

Le signal d'alerte SA1 informe l'unité logique UL de la possibilité d'un actionnement imminent de l'organe de consigne K1, dont l'état est dorénavant scruté à une fréquence plus élevée, la fréquence de scrutation de l'organe de consigne K2 reprenant une valeur standard.

Parallèlement, le signal d'alerte SA1 éveille l'émetteur E1, qui émet le signal d'information SI1.

Le signal SI1 éclaire un pictogramme informant l'opérateur que l'organe de consigne K1 est par exemple dédié à la commande de dégivrage de la lunette arrière, l'éclairage pouvant être suffisant pour permettre à l'opérateur de repérer les emplacements voisins X0 et X2.

L'opérateur, qui souhaite effectivement déclencher le dégivrage de la lunette arrière, fait passer l'organe de consigne K1 de l'état passif à l'état actif (figure 3D) .

Dans la mesure où l'organe de consigne K1 faisait l'objet d'une scrutation privilégiée, son changement d'état est pris en compte au bout d'un intervalle de temps insignifiant au regard du temps de réaction du conducteur.

La fonction de dégivrage de la lunette arrière ayant ainsi été activée, le signal de validation SV1 est produit pour confirmer et rappeler que cette fonction est active (figure 3E).

Chaque détecteur de proximité tel que D1 et D2 peut être constitué par un capteur capacitif purement statique, c'est-à-dire dépourvu de pièce mobile, comme illustré aux figures 4 et 5.

Un tel capteur comprend typiquement une électrode constituée par une armature Afi électriquement conductrice, pouvant être recouverte d'une fine couche de matière. L'armature Afi est reliée à un potentiel de référence à travers un montage série incluant un circuit électronique CC.

Lorsque le doigt O s'approche de l'armature Afi, ce doigt remplit lui-même le rôle d'une nouvelle armature, de sorte que l'armature Afi se trouve reliée au potentiel de référence à travers une capacité supplémentaire variable Cs, qui dépend de la distance L séparant le doigt O de l'armature Afi, et dont la valeur est en permanence surveillée par le circuit électronique CC.

Dès que le circuit CC détecte que la valeur de la capacité Cs indique que la distance L entre le doigt O et l'armature Afi est devenue inférieure à une valeur Li, ce circuit CC délivre le signal d'alerte SA.

En variante, chaque détecteur de proximité tel que D1 et D2, ou l'un au moins d'entre eux, peut être constitué par un capteur capacitif doté d'une armature mobile Am, comme illustré à la figure 6.

Dans ce cas, une capacité variable est formée entre une armature fixe Af et cette armature mobile Am.

L'armature mobile Am peut être déplacée par le doigt O à l'encontre d'une force élastique de rappel, qui peut être exercée par cette armature Am elle-même si elle est par exemple réalisée sous la forme d'une capsule métallique à déformation élastique.

Comme dans le cas précédent, un circuit électronique (non représenté) surveille la valeur de la capacité variable ainsi formée, cette valeur dépendant de la distance séparant les armatures Am et Af, et donc de la distance séparant le doigt O de l'armature fixe Af.

Le cas échéant, la capsule métallique peut être utilisée non seulement comme armature, mais également comme interrupteur, et former un contact galvanique lorsque la seconde condition de proximité est réalisée.

Les organes de consigne K1 et K2 peuvent prendre plusieurs formes de réalisation, et notamment être constitués par des boutons, des interrupteurs ou des potentiomètres, la figure 4 représentant par exemple un organe de consigne K sous la forme d'un bouton actionnant un interrupteur électrique.

L'agencement illustré sur cette figure 4 met en oeuvre le procédé de l'invention de façon telle que le signal de validation SV, par exemple SV1 ou SV2, n'est pas produit par l'émetteur E, mais par une source indépendante SL'.

Le signal de validation SV est ainsi différent du signal d'information SI, c'est-à-dire du signal SI1 ou SI2 produit par l'émetteur E1 ou E2, de sorte que la sous-procédure de validation peut supprimer le signal d'information SI1 ou SI2 dès que la première condition de proximité cesse d'être réalisée, le signal de validation SV prenant éventuellement le relais pour informer l'opérateur, lorsque c'est le cas, que la fonction contrôlée par l'organe de consigne K est active, et par exemple que le récepteur électrique R est alimenté en courant électrique.

Néanmoins, il est possible de prévoir que l'émetteur E1 ou E2 continue de produire, en tant que signal de validation SV1 ou SV2, le signal d'information SI1 ou SI2 même après disparition de la première condition de proximité, pour autant que la fonction contrôlée par l'organe de consigne K1 ou K2 ait été activée.

Cette possibilité est par exemple mise en oeuvre par l'agencement de la figure 5, qui illustre un autre aspect de l'invention qui, bien qu'optionnel, justifie grandement l'intérêt de l'invention.

En effet, au lieu d'avoir recours à des composants physiques indépendants pour constituer les organes de consigne K et les détecteurs D, le procédé illustré à la figure 5 propose de mettre en oeuvre des détecteurs D qui constituent eux-mêmes des organes de consigne.

Pour ce faire, les détecteurs D1 et D2 sont par exemple sensibles à la réalisation, à l'emplacement que chacun d'eux occupe, d'une seconde condition de proximité, et opèrent chacun, en réponse à la réalisation de cette seconde condition de proximité, un changement d'état de la fonction assignée à l'organe de consigne associé.

Selon un premier mode de mise en oeuvre possible, la seconde condition de proximité est considérée comme réalisée lorsque la distance L qui sépare le doigt O de l'emplacement X1 ou X2 dont il s'approche est inférieure à un second seuil déterminé Lj, inférieur au premier seuil Li précédemment mentionné.

Selon un autre mode de mise en oeuvre possible, la seconde condition de proximité est considérée comme réalisée lorsque le doigt O se rapproche rapidement de l'emplacement X1 ou X2, c'est-à-dire lorsque la distance L séparant ce doigt de l'emplacement X1 ou X2 considéré diminue à une vitesse dL/dT supérieure à une vitesse limite déterminée VL.

Dès que la seconde condition de proximité est réalisée, le détecteur D disposé à l'emplacement considéré délivre un signal de consigne Sk destiné à modifier l'état de la fonction contrôlée par ce détecteur, qui en l'occurrence agit donc également en organe de consigne K.

La fonction assignée à cet organe de consigne - détecteur peut ainsi être contrôlée pour passer d'un état passif à un état actif par réalisation de la seconde condition de proximité.

Dans ce cas, il peut être avantageux de prévoir que la réalisation suivante de la seconde condition de proximité au même emplacement fasse passer la fonction considérée de son état actif à son état passif, c'est-à-dire que l'organe de consigne - détecteur D, K présente un fonctionnement bistable et modifie systématiquement l'état de la fonction qui lui est assignée à chaque fois que la seconde condition de proximité est réalisée.

Dans le cas où les organes de consigne prennent la forme de détecteurs de proximité par exemple constitués par des capteurs capacitifs, il est aisé de les disposer sous un panneau translucide du tableau de bord B de telle sorte qu'ils soient invisibles en l'absence de tout signal.

Néanmoins, il peut alors être judicieux de prévoir, sur le tableau de bord B, un ou plusieurs reliefs formant un ou plusieurs guides tactiles pour le doigt ou la main O de l'opérateur.

## Revendications

1. Procédé de gestion et d'exploitation d'un réseau de commande multiplexé comprenant au moins des premier et second organes de consigne (K1, K2) appartenant à un ensemble d'organes de consigne multiplexés, une unité logique de commande (UL), et des premier et second organes commandés (W1, W2) appartenant à un ensemble d'organes commandés et respectivement associés aux premier et second organes de consigne (K1, K2), ce procédé comprenant au moins une procédure de consigne, dans laquelle au moins un organe de consigne (K1, K2), sélectionné parmi les premier et second organes de consigne par un organe de manipulation (O) tel qu'un doigt d'un opérateur, est actionné par cet organe de manipulation (O) et corrélativement déplacé d'un état initial vers un état final choisi parmi au moins deux états différents possibles, une procédure de scrutation, dans laquelle l'état de chaque organe de consigne (K1, K2) est scruté par l'unité logique (UL) au moins pendant chaque cycle d'une série de cycles de scrutation successifs (CSm) présentant chacun une durée au plus égale à une durée maximale déterminée (DT0), et une procédure de commande, dans laquelle l'unité logique (UL) réalise à chaque instant (Tm) un pilotage des premier et second organes commandés (W1, W2) en fonction des états respectifs des premier et second organes de consigne (K1, K2) tels que relevés au cours d'un cycle de scrutation (CSm-1) antérieur à cet instant, la procédure de consigne mettant au moins en oeuvre un détecteur de proximité (D1) émettant un signal d'alerte (SA1) en cas de détection d'une première condition de proximité réalisée entre l'organe de manipulation (O) et le premier organe de consigne (K1) et annonçant la sélection de ce premier organe de consigne (K1), **caractérisé en ce que** le signal d'alerte (SA1) ainsi émis est utilisé par l'unité logique (UL) pour préparer une modification du pilotage du premier organe commandé (W1), en fonction d'un possible changement d'état du premier organe de consigne (K1).

2. Procédé selon la revendication 1, **caractérisé en ce que** le signal d'alerte (SA1) émis est également utilisé par l'unité logique (UL) pour écourter la durée d'au moins un prochain cycle de scrutation (CSm+1) du premier organe de consigne (K1).

3. Procédé suivant la revendication 1 ou 2, **caractérisé en ce que** la première condition de proximité entre l'organe de manipulation (O) et un organe de consigne (K1, K2) est réalisée lorsque l'organe de manipulation (O) est séparé de cet organe de consigne (K1, K2) par une distance (L) inférieure à un premier seuil déterminé (Li).

4. Procédé suivant l'une des revendications précédentes, **caractérisé en ce que** la procédure de consigne met au moins en oeuvre des premier et second détecteurs de proximité (D1, D2) émettant des premier et second signaux d'alerte respectifs (SA1, SA2) dès qu'ils détectent que la première condition de proximité est réalisée respectivement entre les premier et second organes de consigne (K1, K2) et l'organe de manipulation (O), annonçant respectivement la sélection des premier et second organes de consigne (K1, K2), et **en ce que** chaque signal d'alerte (SA1, SA2) ainsi émis est utilisé par l'unité logique (UL) pour écourter la durée d'au moins un prochain cycle de scrutation (CSm+1) de l'organe de consigne (K1, K2) sélectionné ou en passe de l'être, et /ou préparer, en fonction d'un possible changement d'état de l'organe de consigne (K1, K2) sélectionné ou en passe de l'être, une modification du pilotage de l'organe commandé (W1, W2) qui est associé à l'organe de consigne (K1, K2) sélectionné ou en passe de l'être.

5. Procédé suivant la revendication 4, **caractérisé en ce que** les premier et second organes de consigne (K1, K2) sont disposés en des premier et second emplacements respectifs (X1, X2) auxquels sont aussi respectivement disposés les premier et second détecteurs de proximité (D1, D2), et des premier et second émetteurs (E1, E2) de signaux d'information avec lesquels les premier et second organes de consigne (K1, K2) et les premier et second détecteurs de proximité (D1, D2) sont ainsi respectivement mis en correspondance, et **en ce que** chaque émetteur (E1, E2) produit, en cas d'émission d'un signal d'alerte (SA1, SA2) par le détecteur de proximité correspondant (D1, D2), un signal d'information (SI1, SI2) rappelant à l'opérateur quel organe commandé (W1, W2) est associé à l'organe de consigne (K1, K2) qui correspond à l'émetteur (E1, E2) de ce signal d'information.

6. Procédé suivant l'une quelconque des revendications 1 à 5, **caractérisé en ce que** les premier et second organes de consigne (K1, K2) sont disposés en des premier et second emplacements respectifs (X1, X2), **en ce que** chacun des premier et second organes de consigne (K1, K2) adopte sélectivement un état actif ou un état passif, et **en ce que** la procédure de commande comprend une sous-procédure de validation, consistant au moins à produire un signal de validation (SV1, SV2) à chacun des premier et second emplacements (X1, X2) où est disposé un organe de consigne (K1, K2) placé dans son état actif.

7. Procédé suivant l'une des revendications 1 à 3, **caractérisé en ce que** le détecteur de proximité (D) est disposé de manière à pouvoir détecter une réalisation de la première condition de proximité entre l'organe de manipulation (O) et l'un ou l'autre des premier et second organes de consigne (K1, K2), le signal d'alerte (SA) émis par ce détecteur de proximité (D) annonçant ainsi la sélection de l'un ou l'autre des premier et second organes de consigne (K1, K2), et **en ce que** ce signal d'alerte (SA) est utilisé par l'unité logique (UL) pour écourter la durée d'au moins un prochain cycle de scrutation (CSm+1) des premier et second organes de consigne (K1, K2), et / ou préparer une modification du pilotage des premier et second organes commandés (W1, W2), en fonction d'un possible changement des états des premier et second organes de consigne (K1, K2).

8. Procédé suivant l'une quelconque des revendications précédentes, **caractérisé en ce que** les premier et second organes de consigne (K1, K2) sont constitués par des boutons, des interrupteurs ou des potentiomètres.

9. Procédé suivant l'une quelconque des revendications 1 à 6 combinée à la revendication 4, **caractérisé en ce que** les premier et second détecteurs (D1, D2) constituent eux-mêmes les premier et second organes de consigne (K1, K2), chaque organe de consigne (K1, K2) étant sensible à une seconde condition de proximité entre lui-même et l'organe de manipulation (O), et changeant d'état par réalisation de cette seconde condition de proximité.

10. Procédé suivant la revendication 9, **caractérisé en ce que** chacun des premier et second organes de consigne (K1, K2) passe d'un état passif à un état actif par réalisation de la seconde condition de proximité.

11. Procédé suivant la revendication 9 ou 10, **caractérisé en ce que** chacun des premier et second organes de consigne (K1, K2) passe d'un état actif à un état passif par réalisation de la seconde condition de proximité.

12. Procédé suivant l'une quelconque des revendications 9 à 11 combinée à la revendication 3, **caractérisé en ce que** la seconde condition de proximité entre l'organe de manipulation (O) et un organe de consigne (K1, K2) est réalisée lorsque l'organe de manipulation (O) est séparé de cet organe de consigne (K1, K2) par une distance (L) inférieure à un second seuil déterminé (Lj), inférieur au premier seuil (Li).

13. Procédé suivant l'une quelconque des revendications 9 à 11, **caractérisé en ce que** la seconde condition de proximité entre l'organe de manipulation (O) et un organe de consigne (K1, K2) est réalisée lorsque l'organe de manipulation (O) est séparé de cet organe de consigne (K1, K2) par une distance (L) qui diminue à une vitesse (dL/dT) supérieure à une vitesse limite déterminée (VL).

14. Procédé suivant l'une quelconque des revendications précédentes combinée à la revendication 5, **caractérisé en ce que** le signal d'information (SI1, SI2) est un signal lumineux, un signal sonore, un signal vibratoire, ou un message parlé.

15. Procédé suivant l'une quelconque des revendications précédentes combinée à la revendication 6, **caractérisé en ce que** le signal de validation (SV1, SV2) est un signal lumineux.

16. Procédé suivant l'une quelconque des revendications précédentes, **caractérisé en ce que** le réseau de commande multiplexé est embarqué sur un véhicule automobile, et **en ce que** chaque emplacement (X1, X2) appartient à un poste de conduite de ce véhicule.

17. Procédé suivant l'une quelconque des revendications précédentes combinée aux revendications 5 et 16, **caractérisé en ce qu'**il met en oeuvre, sur le poste de conduite, au moins un relief formant un guide tactile pour l'organe de manipulation (O).

18. Procédé suivant l'une quelconque des revendications précédentes combinée aux revendications 5, 6 et 16, **caractérisé en ce que** les premier et second emplacements (X1, X2) appartiennent à un tableau de bord (B) du véhicule et **en ce qu'**en l'absence de tout signal d'information (SI1, SI2) et de tout signal de validation (SV1, SV2) , les premier et second emplacements (X1, X2) sont indifférenciés.

19. Procédé suivant l'une quelconque des revendications précédentes combinée aux revendications 5, 6 et 16, **caractérisé en ce que** les premier et seconds détecteurs de proximité (D1, D2) et les premier et second émetteurs (E1, E2) de signaux d'information sont disposés sous un panneau translucide d'un tableau de bord (B) du véhicule.

20. Procédé suivant les revendications 8 et 16 considérées dans leur rattachement à la revendication 7, **caractérisé en ce que** le détecteur de proximité est porté par un combinateur (CB) du véhicule, et **en ce que** les premier et second organes de consigne (K1, K2) sont constitués par des contacts électriques et / ou des rhéostats portés par le combinateur (CB).

21. Procédé suivant l'une quelconque des revendications précédentes combinée à la revendication 4, **caractérisé en ce que** l'un au moins des premier et second détecteurs de proximité (D1, D2) est un capteur capacitif dépourvu de pièce mobile.

22. Procédé suivant l'une quelconque des revendications précédentes combinée à la revendication 4, **caractérisé en ce que** l'un au moins des premier et second détecteurs de proximité (D1, D2) est un capteur capacitif doté d'une armature mobile (Am) sélectivement déplacée par l'organe de manipulation (O) à l'encontre d'une force élastique de rappel.

## Patentansprüche

1. Verfahren zum Leiten und Betreiben eines Multiplex-Steuemetzes, mit zumindest einem ersten und einem zweiten Eingabeglied (K1, K2), die zu einer Gruppe von Multiplex-Eingabegliedern gehören, einer logischen Steuereinheit (UL) und mit einem ersten und einem zweiten zu steuernden Glied (W1, W2), die zu einer Gruppe von zu steuernden Gliedern gehören und dem ersten bzw. zweiten Eingabeglied (K1, K2) zugeordnet sind, wobei dieses Verfahren zumindest einen Eingabevorgang umfasst, bei dem zumindest ein zwischen dem ersten und dem zweiten Eingabeglied über ein Bedienglied (O), wie etwa dem Finger eines Anwenders, ausgewähltes Eingabeglied (K1, K2) über dieses Bedienglied (O) betätigt wird und entsprechend von einem Ausgangszustand in einen Endzustand verlagert wird, der zwischen zumindest zwei möglichen unterschiedlichen Zuständen ausgewählt ist, und einen Abfragevorgang, in dem der Zustand eines jeden Eingabeglieds (K1, K2) von der logischen Einheit (UL) zumindest während eines jeden Zyklus einer Reihe von aufeinander folgenden Abfragezyklen (CSm) abgefragt wird, die jeweils eine Zeitdauer aufweisen, die höchstens gleich einer vorbestimmten Höchstdauer (DT0) ist, und einen Steuervorgang, bei dem die logische Einheit (UL) zu jedem Zeitpunkt (Tm) ein Ansteuern des ersten und des zweiten zu steuernden Glieds (W1, W2) in Abhängigkeit von den jeweiligen Zuständen des ersten und des zweiten Eingabeglieds (K1, K2) durchführt, wie sie im Laufe eines vor diesem Zeitpunkt erfolgten Abfragezyklus (CSm-1) aufgenommen werden, wobei bei dem Eingabevorgang zumindest ein Näherungssensor (D1) Anwendung findet, der bei Erfassen einer zwischen dem Bedienglied (O) und dem ersten Eingabeglied (K1) erfühlen ersten Näherungsbedingung ein Alarmsignal (SA1) ausgibt und die Auswahl dieses ersten Eingabeglieds (K1) meldet, **dadurch gekennzeichnet, dass** das so ausgegebene Alarmsignal (SA1) von der logischen Einheit (UL) zum Einleiten einer Änderung der Ansteuerung des zu steuernden ersten Glieds (W1) in Abhängigkeit von einem möglichen Zustandswechsel des ersten Eingabeglieds (K1) benutzt wird.

2. Verfahren nach Anspruch 1, **dadurch gekennzeichnet, dass** das ausgegebene Alarmsignal (SA1) von der logischen Einheit (UL) auch dazu benutzt wird, die Dauer zumindest eines nachfolgenden Abfragezyklus (CSm+1) des ersten Eingabeglieds (K1) zu verkürzen.

3. Verfahren nach Anspruch 1 oder 2, **dadurch gekennzeichnet, dass** die erste Näherungsbedingung zwischen dem Bedienglied (O) und dem Eingabeglied (K1, K2) dann erfüllt ist, wenn das Bedienglied (O) von diesem Eingabeglied (K1, K2) durch einen Abstand (L) getrennt ist, der kleiner ist als ein bestimmter erster Schwellwert (Li).

4. Verfahren nach einem der vorangehenden Ansprüche, **dadurch gekennzeichnet, dass** bei dem Eingabevorgang zumindest ein erster und ein zweiter Näherungssensor (D1, D2) Anwendung finden, die ein erstes bzw. zweites Alarmsignal (SA1, SA2) ausgeben, sobald sie erfassen, dass die erste Näherungsbedingung zwischen dem ersten bzw. zweiten Eingabeglied (K1, K2) und dem Bedienglied (O) erfüllt ist, und die Auswahl des ersten bzw. des zweiten Eingabeglieds (K1, K2) melden, und dass jedes so ausgegebene Alarmsignal (SA1, SA2) von der logischen Einheit (UL) dazu benutzt wird, die Dauer zumindest eines nachfolgenden Abfragezyklus (CSm+1) des Eingabeglieds (K1, K2) zu verkürzen, das ausgewählt wurde oder gerade ausgewählt wird, und/oder um in Abhängigkeit von einem möglichen Zustandswechsel des Eingabeglieds (K1, K2), das ausgewählt wurde oder gerade ausgewählt wird, eine Änderung der Ansteuerung des zu steuernden Glieds (W1, W2) einzuleiten, das dem Eingabeglied (K1, K2) zugeordnet ist, das ausgewählt wurde oder gerade ausgewählt wird.

5. Verfahren nach Anspruch 4, **dadurch gekennzeichnet, dass** das erste und das zweite Eingabeglied (K1, K2) an einer ersten bzw. einer zweiten Stelle (X1, X2) angeordnet sind, an der auch der erste bzw. der zweite Näherungssensor (D1, D2) und ein erster bzw. ein zweiter Sender (E1, E2) zum Senden von Informationssignalen angeordnet sind, mit denen das erste bzw. das zweite Eingabeglied (K1, K2) und der erste bzw. der zweite Näherungssensor (D1, D2) somit verknüpft sind, und dass jeder Sender (E1, E2) bei Ausgeben eines Alarmsignals (SA1, SA2) von dem entsprechenden Näherungssensor (D1, D2) ein Informationssignal (SI1, SI2) erzeugt, das den Anwender daran erinnert, welches zu steuernde Glied (W1, W2) dem Eingabeglied (K1, K2) zugeordnet ist, das dem Sender (E1, E2) dieses Informationssignals entspricht.

6. Verfahren nach einem der Ansprüche 1 bis 5, **dadurch gekennzeichnet, dass** das erste und das zweite Eingabeglied (K1, K2) an der ersten bzw. zweiten Stelle (X1, X2) angeordnet sind, dass das erste und das zweite Eingabeglied (K1, K2) jeweils einen aktiven Zustand bzw. einen passiven Zustand annehmen, und dass der Steuervorgang einen untergeordneten Freigabevorgang umfasst, der zumindest darin besteht, ein Freigabesignal (SV1, SV2) jeweils an der ersten und der zweiten Stelle (X1, X2) zu erzeugen, wo ein Eingabeglied (K1, K2) angeordnet ist, das in seinen aktiven Zustand gebracht ist.

7. Verfahren nach einem der Ansprüche 1 bis 3, **dadurch gekennzeichnet, dass** der Näherungssensor (D) so angeordnet ist, dass er eine Erfüllung der ersten Annäherungsbedingung zwischen dem Bedienglied (O) und dem einen oder anderen des ersten und zweiten Eingabeglieds (K1, K2) erfassen kann, wobei das von diesem Näherungssensor (D) ausgegebene Alarmsignal (SA) somit die Auswahl des einen oder anderen des ersten und zweiten Eingabeglieds (K1, K2) meldet, und dass dieses Alarmsignal (SA) von der logischen Einheit (UL) dazu benutzt wird, die Dauer zumindest eines nachfolgenden Abfragezyklus (CSm+1) des ersten und des zweiten Eingabeglieds (K1, K2) zu verkürzen und/oder eine Änderung der Ansteuerung des zu steuernden ersten und zweiten Glieds (W1, W2) in Abhängigkeit von einem möglichen Zustandswechsel des ersten und des zweiten Eingabeglieds (K1, K2) einzuleiten.

8. Verfahren nach einem der vorangehenden Ansprüche, **dadurch gekennzeichnet, dass** das erste und das zweite Eingabeglied (K1, K2) aus Knöpfen, Schaltern oder Potentiometern besteht.

9. Verfahren nach einem der Ansprüche 1 bis 6 in Kombination mit Anspruch 4, **dadurch gekennzeichnet, dass** der erste und der zweite Sensor (D1, D2) selbst das erste und das zweite Eingabeglied (K1, K2) bildet, wobei jedes Eingabeglied (K1, K2) gegenüber einer zweiten Näherungsbedingung zwischen diesem und dem Bedienglied (O) empfindlich ist und mit Erfüllung dieser zweiten Näherungsbedingung seinen Zustand ändert.

10. Verfahren nach Anspruch 9, **dadurch gekennzeichnet, dass** mit Erfüllung der zweiten Näherungsbedingung das erste und das zweite Eingabeglied (K1, K2) jeweils von einem passiven Zustand in einen aktiven Zustand übergehen.

11. Verfahren nach Anspruch 9 oder 10, **dadurch gekennzeichnet, dass** mit Erfüllung der zweiten Näherungsbedingung das erste und das zweite Eingabeglied (K1, K2) jeweils von einem aktiven Zustand in einen passiven Zustand übergehen.

12. Verfahren nach einem der Ansprüche 9 bis 11 in Kombination mit Anspruch 3, **dadurch gekennzeichnet, dass** die zweite Näherungsbedingung zwischen dem Bedienglied (O) und einem Eingabeglied (K1, K2) dann erfüllt ist, wenn das Bedienglied (O) von diesem Eingabeglied (K1, K2) durch einen Abstand (L) getrennt ist, der kleiner ist als ein bestimmter zweiter Schwellwert (Lj), der kleiner als der erste Schwellwert (Li) ist.

13. Verfahren nach einem der Ansprüche 9 bis 11, **dadurch gekennzeichnet, dass** die zweite Näherungsbedingung zwischen dem Bedienglied (O) und dem Eingabeglied (K1, K2) dann erfüllt ist, wenn das Bedienglied (O) von diesem Eingabeglied (K1, K2) durch einem Abstand (L) getrennt ist, der mit einer Geschwindigkeit (dL/dT) abnimmt, die höher als eine bestimmte Grenzgeschwindigkeit (VL) ist.

14. Verfahren nach einem der vorangehenden Ansprüche in Kombination mit Anspruch 5, **dadurch gekennzeichnet, dass** das Informationssignal (SI1, SI2) ein Lichtsignal, ein Tonsignal, ein Vibrationssignal oder eine gesprochene Nachricht ist.

15. Verfahren nach einem der vorangehenden Ansprüche in Kombination mit Anspruch 6, **dadurch gekennzeichnet, dass** das Freigabesignal (SV1, SV2) ein Lichtsignal ist.

16. Verfahren nach einem der vorangehenden Ansprüche, **dadurch gekennzeichnet, dass** das Multiplex-Steuemetz bei einem Kraftfahrzeug mitgeführt wird und dass jede Stelle (X1, X2) zu einem Fahrerplatz dieses Fahrzeugs gehört.

17. Verfahren nach einem der vorangehenden Ansprüche in Kombination mit Anspruch 5 und 16, **dadurch gekennzeichnet, dass** am Fahrerplatz zumindest eine Erhebung vorgesehen ist, die eine Tastführung für das Bedienglied (O) bildet.

18. Verfahren nach einem der vorangehenden Ansprüche in Kombination mit Anspruch 5, 6 und 16, **dadurch gekennzeichnet, dass** die erste und die zweite Stelle (X1, X2) zu einem Armaturenbrett (B) des Fahrzeugs gehören und dass bei Fehlen von jeglichem Informationssignal (SI1, SI2) und von jeglichem Freigabesignal (SV1, SV2) die erste und die zweite Stelle (X1, X2) indifferent sind.

19. Verfahren nach einem der vorangehenden Ansprüche in Kombination mit Anspruch 5, 6 und 16, **dadurch gekennzeichnet, dass** der erste und der zweite Näherungssensor (D1, D2) und der erste und der zweite Sender (E1, E2) der Informationssignale unter einer lichtdurchlässigen Platte eines Armaturenbretts (B) des Fahrzeugs angeordnet sind.

20. Verfahren nach Anspruch 8 und 16 bei Anbetracht in Abhängigkeit von Anspruch 7, **dadurch gekennzeichnet, dass** der Näherungssensor von einer Schaltereinrichtung (CB) des Fahrzeugs getragen wird und dass das erste und das zweite Eingabeglied (K1, K2) aus elektrischen Kontakten und/oder Regelwiderständen bestehen, die von der Schaltereinrichtung (CB) getragen werden.

21. Verfahren nach einem der vorangehenden Ansprüche in Kombination mit Anspruch 4, **dadurch gekennzeichnet, dass** zumindest einer des ersten und des zweiten Näherungssensors (D1, D2) ein kapazitiver Sensor ohne bewegliches Teil ist.

22. Verfahren nach einem der vorangehenden Ansprüche in Kombination mit Anspruch 4, **dadurch gekennzeichnet, dass** zumindest einer des ersten und des zweiten Näherungssensors (D1, D2) ein kapazitiver Sensor ist, der mit einem beweglichen Organ (Am) versehen ist, das von dem Bedienglied (O) entgegen einer elastischen Rückstellkraft selektiv verlagert wird.

## Claims

1. Method for managing and operating a network of multiplexed controlling devices comprising at least a first and a second controlling device (K1, K2) belonging to a multiplexed controlling devices assembly, a logic control unit (UL) and first and second controlled device (W1, W2) forming part of an assembly of controlled devices and linked respectively to the first and second controlling devices (K1, K2); this method, which comprises at least one control procedure, in which at least one controlling device (K1, K2) selected from the first and second controlling devices by an operating instrument (O), such as an operator's finger, is activated by this operating instrument (O) and consequently moved from an initial state to a final state chosen from at least two possible different states, a scanning process in which the status of each controlling device (K1, K2) is scanned by the logic unit (UL) at least during each cycle of a series of successive scanning cycles (CSm) each having a duration at least equal to a specified maximum duration (DT0), and a control procedure in which the logic unit (UL) effects each time (Tm) an operation of the first and second devices controlled (W1, W2) according to the respective states of the first and second controlling devices (K1, K2) as detected during a scanning cycle (CSm-1) prior to this time, the control method at least operates a proximity detector (D1) emitting an alert signal (SA1) in the event of detecting an initial proximity condition produced between the operating instrument (O) and the first controlling device (K1) and announcing the selection of this first controlling device (K1), **characterised in that** the alert signal (SA1) emitted in this instance is used by the logic unit (UL) to prepare a change in the operation of the first controlled device (W1) in accordance with a possible change in the condition of the first controlling device (K1).

2. Method in accordance with claim 1, **characterised in that** the emitted alert signal (SA1) is also used by the logic unit (UL) to shorten the time by at least one further scanning cycle (CSm+1) of the first controlling device (K1).

3. Method in accordance with claim 1 or 2, **characterised in that** the first proximity condition between the operating instrument (O) and a controlling device (K1, K2) is effected when the operating instrument (O) is separated from this controlling device (K1, K2) by a distance (L) lower than an initial specified threshold (Li).

4. Method in accordance with one of the preceding claims, **characterised in that** the control method operates at least the first and second proximity detectors (D1, D2) which issue the respective first and second alert signals (SA1, SA2) as soon as they detect that the first proximity condition is produced respectively between the first and second controlling devices (K1, K2) and the operating instrument (O), announcing the selection of the first and second controlling devices (K1, K2) respectively and **in that** each alert signal (SA1, SA2) emitted in this manner is used by the logic unit (UL) to shorten the time by at least one further scanning cycle (CSm+1) by the selected controlling device (K1, K2) or relayed by the person and/or to prepare for, according to a possible change of status of the selected controlling device (K1, K2) or relayed by the person, a change in the operation of the controlled device (W1, W2) which is linked to the selected controlling device (K1, K2) or relayed from the person.

5. Method in accordance with claim 4, **characterised in that** the first and second controlling devices (K1, K2) are arranged in the respective first and second sites (X1, X2), for which the respective first and second proximity detectors (D1, D2) and the first and second data signal transmitters (E1, E2) with which the first and second controlling devices (K1, K2) and the first and second proximity detectors (D1, D2) are thus respectively connected and **in that**, in the event of an alert signal being emitted by the corresponding proximity detector (D1, D2), each transmitter (E1, E2) produces an information signal (SI1, SI2) reminding the operator which controlled device (W1, W2) is linked to the controlling device (K1, K2) corresponding to the transmitter (E1, E2) of this information signal.

6. Method in accordance with any one of claims 1 to 5, **characterised in that** the first and second controlling devices (K1, K2) are arranged in the respective first and second sites (X1, X2), **in that** each of the first and second controlling devices (K1, K2) selectively adopts an active state or a passive state and **in that** the control routine comprises a validation sub-routine consisting at least of producing a validation signal (SV1, SV2) in each of the first and second sites (X1, X2) where a controlling device (K1, K2) is placed and set in its active state.

7. Method in accordance with one of claims 1 to 3, **characterised in that** the proximity detector (D) is arranged in such a manner as to be able to detect a production of the first proximity condition between the operating instrument (O) and one or the other of the first and second controlling devices (K1, K2), with the alert signal (SA) transmitted by this proximity detector (D) thus announcing the selection of one or the other of the first and second controlling devices (K1, K2) and **in that** this alert signal (SA) is used by the logic unit (UL) to shorten the time by at least one further scanning cycle (CSm+1) of the first and second controlling devices (K1, K2) and/or to prepare for a change in the operation of the first and second controlled devices (W1, W2) according to a possible change in the states of the first and second controlling devices (K1, K2).

8. Method in accordance with any one of the preceding claims, **characterised in that** the first and second controlling devices (K1, K2) are formed by buttons, switches or potentiometers.

9. Method in accordance with any one of claims 1 to 6 combined with claim 4, **characterised in that** the first and second detectors (D1, D2) themselves form the first and second controlling devices (K1, K2), each controlling device (K1, K2) being sensitive to a second proximity condition between itself and the operating instrument (O) and changing state by achievement of this second proximity condition.

10. Method in accordance with claim 9, **characterised in that** each of the first and second controlling devices (K1, K2) passes from a passive state to an active state by achievement of the second proximity condition.

11. Method in accordance with claim 9 or 10, **characterised in that** each of the first and second controlling devices (K1, K2) passes from an active state to a passive state by achievement of the second proximity condition.

12. Method in accordance with any one of claims 9 to 11 combined with claim 3, **characterised in that** the second proximity condition between the operating instrument (O) and a controlling device (K1, K2) is achieved when the operating instrument (O) is separated from this controlling device (K1, K2) by a distance (L) lower than a second specified threshold (Lj), which is lower than the first threshold (Li).

13. Method in accordance with any one of claims 9 to 11, **characterised in that** the second proximity condition between the operating instrument (O) and a controlling device (K1, K2) is achieved when the operating instrument (O) is separated from the controlling device (K1, K2) by a distance (L) which diminishes at a speed (dL/dT) greater than a specified limit speed (VL).

14. Method in accordance with any one of the previous claims combined with claim 5, **characterised in that** the information signal (SI1, SI2) is a light signal, a sound signal, a vibratory signal or a spoken message.

15. Method in accordance with any one of the previous claims combined with claim 6, **characterised in that** the validation signal (SV1, SV2) is a light signal.

16. Method in accordance with any one of the previous claims, **characterised in that** the multiplexed control network is fitted to an automotive vehicle and **in that** each site (X1, X2) belongs to a control for this vehicle.

17. Method in accordance with any one of the previous claims combined with claims 5 and 16, **characterised in that**, on the control, it at least makes use of a relief pattern forming a tactile guide for the operating instrument (O).

18. Method in accordance with any one of the previous claims combined with claims 5, 6 and 16, **characterised in that** the first and second sites (X1, X2) form part of a vehicle dashboard (B) and **in that** in the absence of any information signal (SI1, SI2) and any validation signal (SV1, SV2), the first and second sites (X1, X2) are undifferentiated.

19. Method in accordance with any one of the previous claims combined with claims 5, 6 and 16, **characterised in that** the first and second proximity detectors (D1, D2) and the first and second information signal transmitters (E1, E2) are arranged beneath a translucent panel of a vehicle's dashboard (B).

20. Method in accordance with claims 8 and 16 considered with their being linked to claim 7, **characterised in that** the proximity detector is carried by a vehicle switchgroup (CB) and **in that** the first and second controlling devices (K1, K2) are formed by electrical contacts and/or rheostats carried by the switchgroup (CB).

21. Method in accordance with any one of the previous claims combined with claim 4, **characterised in that** at least one of the first and second proximity detectors (D1, D2) is a capacitative sensor with no moving parts.

22. Method in accordance with any one of the previous claims combined with claim 4, **characterised in that** at least one of the first and second proximity detectors (D1, D2) is a capacitative sensor equipped with a moving armature (Am) selectively shifted by the operating instrument (O) against an elastic return force.
